## Europäisches Patentamt
## European Patent Office
## Office européen des brevets

(19)

(11) Veröffentlichungsnummer: **0 125 737**
**B1**

(12)

# EUROPÄISCHE PATENTSCHRIFT

(45) Veröffentlichungstag der Patentschrift:
**15.07.87**

(21) Anmeldenummer: **84200679.3**

(22) Anmeldetag: **14.05.84**

(51) Int. Cl.⁴: **H 01 R 4/02,** H 05 K 7/02,
H 05 K 3/34, H 01 F 5/04

(54) Steckanordnung und Verfahren zum Verzinnen derselben vor dem Einstecken in Leiterplatten.

(30) Priorität: **17.05.83 CH 2674/83**

(43) Veröffentlichungstag der Anmeldung:
**21.11.84 Patentblatt 84/47**

(45) Bekanntmachung des Hinweises auf die Patenterteilung:
**15.07.87 Patentblatt 87/29**

(84) Benannte Vertragsstaaten:
**AT CH DE FR GB IT LI**

(56) Entgegenhaltungen:
**DE - A - 1 110 258**
**DE - A - 2 903 793**
**DE - A - 3 312 536**
**DE - B - 1 949 413**
**FR - A - 1 392 960**
**FR - A - 2 403 634**

(73) Patentinhaber: **METEOR AG, Moosstrasse 7,
CH-8803 Rüschlikon (CH)**

(72) Erfinder: **Arnold, Ernst, Nassenwilerweg 12,
CH-8102 Buchs (CH)**

(74) Vertreter: **Schütz, Peter, Dipl.-Ing. et al, Patentanwälte
Dr. Dieter v. Bezold Dipl.-Ing. Peter Schütz Dipl.-Ing.
Wolfgang Heusler
Maria-Theresia-Strasse 22 Postfach 86 02 60,
D-8000 München 86 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft eine Steckanordnung für Leiterplatten gemäss dem Oberbegriff des Patentanspruchs 1.

Für das Bestücken von Leiterplatten mit elektrischen Komponenten, insbesondere mit Spulen, werden vorzugsweise Spulenkörper mit verzinnten Kontaktstiften verwendet, an welche die Spulenenden angedrillt, verlötet und in die entsprechenden Öffnungen in der Leiterplatte eingesteckt und mit dieser ebenfalls verlötet werden.

Aus der FR-A 24 03 634 sind winkelförmige Lötfahnen aus metallischem Werkstoff für Spulenkörper bekannt, die in Flanschteile des Spulenkörpers eingebettet werden und mit einem herausragenden Schenkel durch Öffnungen einer Leiterplatte gesteckt und mit einer auf der gegenüberliegenden Seite der Leiterplatte befindlichen Leiterbahn verlötet werden können. Der andere Schenkel ragt seitlich aus dem Spulenkörper heraus und hat ein hakenförmiges Ende zum Befestigen des Spulenendes sowie von Anschlussdrähten.

Aus der DE-A-29 03 793 sind Löteinsätze für Leiterplatten bekannt, die aus Blechteilen mit Löchern zum Durchtritt des Lots ausgebildet oder auch aus Draht gewickelt sein können und in Öffnungen der Leiterplatte eingesetzt werden. In die dadurch gebildete Öffnung können Drähte eingesteckt und durch einlaufendes Lot verankert werden.

Weiterhin sind aus der DE-B-19 49 413 profilierte metallische Anschlussstifte für Kunststoffspulenkörper bekannt, deren Profilierung in Axialrichtung oder schraubenförmig verläuft. Um die profilierten Bereiche können Drähte in der sogenannten «Wire-Wrap-Technik» herumgewickelt und festgelegt werden. Schliesslich sind aus der DE-A-11 10 258 Lötstützpunkte aus einem Kunststoffkörper, z.B. Spulenkörper, und mit diesem einstückigen Zapfen oder Stegen bekannt, die Nuten zur Fixierung eingelegter Drähte aufweisen, die an dem Lötstützpunkt mit anderen herumgewickelten Drähten verlötet werden.

Bei Verwendung von einfach isolierten Kupferlackdrähten, deren Isolierschicht durch die Wärmeeinwirkung beim Verlöten verdampft, ergeben sich normalerweise im Lötbad keinerlei Schwierigkeiten.

Bei einer Verwendung von mehrfach isolierten Kupferlackdrähten, die an sich schwer lötfähig sind und wesentlich höhere Temperaturen erfordern, beispielsweise 480 bis 500 °C gegenüber den einfach isolierten Drähten von Temperaturen unterhalb von 400 °C und einer wesentlich längeren Lötzeit von über 5 Sekunden, ergeben sich Schwierigkeiten, die darin bestehen, dass einmal die Löteigenschaften z.B. durch übermässige Schlackenbildung verschlechtert werden, zum anderen eine unregelmässige Verzinnung der Kontaktstifte auftritt, bedingt durch die fehlende Wärmeleitfähigkeit z.B. des Kunststoffes, wodurch die am Kunststoff anliegenden Drahtenden noch Lackrückstände aufweisen können und Schmelzdämpfe des Isoliermaterials explosionsartig an die Oberfläche treten können, wodurch Zinnspritzer und Blasenbildung auftreten können. Da weiterhin der Abstand zwischen den einzelnen Kontaktstiften sehr klein ist, besteht die Gefahr der Brückenbildung und somit das Auftreten von Kurzschlüssen. Für die Verwendung automatischer Lötverfahren wird zudem eine dauernde Überwachung des Lötvorganges erforderlich. Selbst bei intensiver Überwachung ist eine ungleichmässige Lötqualität der einzelnen Stifte und somit eine hohe Ausschussrate unvermeidlich.

Die Aufgabe der Erfindung besteht darin, eine Steckanordnung zur Anbringung elektrischer Spulen mit nichtmetallischen Spulenkörper an Leiterplatten zu schaffen, bei welcher ein sicherer Halt der Drahtenden an den Anschlussstiften nach dem Verlöten gewährleistet ist.

Diese Aufgabe wird erfindungsgemäss durch die kennzeichnenden Merkmale des Patentanspruchs 1 gelöst. Weitere vorteilhafte Ausbildungen der Steckanordnung gehen aus den Unteransprüchen hervor.

Ein Vorteil der erfindungsgemässen ausgebildeten Anschlussstifte besteht insbesondere darin, dass durch ihre Profilierung die daran angedrillten Drahtenden nicht auf der ganzen Oberfläche aufliegen, sondern lediglich auf den Profilerhöhungen. Dadurch besteht die Möglichkeit, dass das Lötzinn auch in die Profilvertiefungen und somit an die Rückseite der Drahtenden gelangt, wodurch die Verzinnung derselben über den ganzen Umfang gleichmässig erfolgt. Weiterhin ist eine Entgasung und ein Entweichen der durch die Löttemperatur abschmelzenden isolierenden Lackschichten innerhalb der Profilvertiefungen möglich. Ein Aufblähen oder explosionsartiges Entweichen dieser Dämpfe durch die Wicklungen wird dadurch verhindert und somit eine gleichmässige Verzinnung sichergestellt. Auch wird verhindert, das einzelne Wicklungslagen verrutschen oder die Verzinnung stellenweise abbröckeln kann.

Auch ist durch die Erfindung möglich, im gleichen Lötbad Spulen mit verschiedenen starken Drähten gleichzeitig zu behandeln.

In der Zeichnung sind verschiedene Ausführungsbeispiele der erfindungsgemässen Anschlussstifte vereinfacht dargestellt.

Es zeigen:

Fig. 1 eine Seitenansicht einer elektrischen Spule mit Anschlussstiften, wobei ein Anschlussstift mit dem Drahtende der Spule bewickelt ist,

Fig. 2 eine weitere Ausbildung einer Spule gemäss Fig. 1, bei welcher die Anschlussstifte seitlich abgewinkelt sind,

Fig. 3a–3b verschiedene mögliche Profilformen der Anschlussstifte und

Fig. 3c–3e mehrteilige Ausbildungsformen von Anschlussstiften.

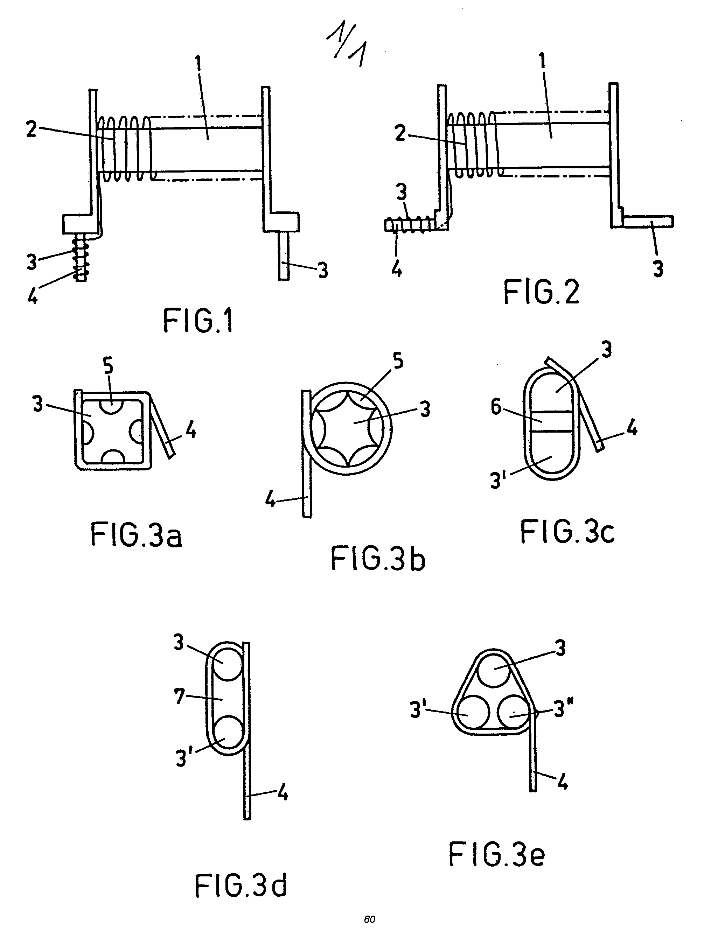

Gemäss den Fig. 1 und 2 ist mit 1 ein Spulenkörper bezeichnet, der Wicklungen 2 aufnimmt und an dessen Unterseite Anschlussstifte 3 angeordnet sind. Der Spulenkörper 1 und die Anschlussstifte 3 bestehen vorzugsweise aus einem Kunststoff und sind aus einem Stück hergestellt. Bei der Darstellung gemäss Fig. 1 sind die Anschlussstifte als Einsteckstifte ausgebildet, während diejenigen gemäss Fig. 2 seitlich abgekröpft, vorzugsweise im Winkel von 90° seitlich abgebogen sind. Die Wicklungen 2 bestehen aus isoliertem Draht, vorzugsweise aus lackiertem Kupferdraht und deren Wicklungsenden 4 werden lagenweise um die Anschlussstifte 3 gewickelt und anschliessend verzinnt. Dabei werden bei der Ausbildung gemäss Fig. 1 die Wicklungsenden 4 so um die Anschlussstifte 3 gewickelt, dass sie beim Einstecken in (nicht dargestellte) Öffnungen einer Leiterplatte einpassen und mit deren ebenfalls nicht gezeigten Anschlüssen verlötet werden können. Bei der Ausbildung der abgewinkelten Anschlussstifte 3 (gemäss Fig. 2) werden die verzinnten Wicklungsenden 4 auf eine Leiterplatte aufgelötet.

Die in den Fig. 1 und 2 beschriebenen Anschlussstifte 3 werden erfindungsgemäss profiliert, einteilig oder mehrteilig ausgebildet, wie in den Fig. 3a–3e beispielsweise dargestellt. In der Ausbildung nach Fig. 3a weisen die Anschlussstifte 3 einen quadratischen Querschnitt auf und sind an der Aussenoberfläche mit Einbuchtungen 5 versehen. Die Wicklungsenden 4 werden so um den Anschlussstift 3 gewickelt, dass die Einbuchtungen 5 von den Wicklungsenden 4 im Abstand überdeckt werden. Die Ausbildung gemäss Fig. 3b zeigt einen sternförmigen Querschnitt des Anschlussstiftes 3, wobei die Wicklungsenden 4 wiederum lagenweise die Einbuchtungen 5 freiliegend überdecken.

Bei den vorstehend beschriebenen einteiligen Ausbildungen der Anschlussstifte 3 wird die jeweilige Einbuchtung 5 beim Verzinnen der Wicklungsenden 4 mit Lötzinn umspült und umschliesst somit die Wicklungsenden 4 von allen Seiten und verbindet dieselben untereinander. Gleichzeitig können während des Verzinnens der Wicklungsenden 4 Gase, die durch die Wärmeeinwirkung auf die Lackisolation der Wicklungsenden 4 entstehen, durch die Einbuchtungen 5 entweichen. Dadurch wird ein Aufblähen der lagenweisen gewickelten Wicklungsenden 4 verhindert.

Wie in den Fig. 3c bis 3e gezeigt, können die Anschlussstifte 3 auch mehrteilig ausgebildet sein. In einer vorteilhaften Ausführung (Fig. 3c) sind die Anschlussstifte 3, 3′ so ausgebildet, dass deren Profile halboval geformt sind und zwischen den Anschlussstiften 3, 3′ ein Spalt 6 vorgesehen ist, der dieselbe Aufgabe hat, wie die Einbuchtungen 5 bei den vorstehend beschriebenen Ausbildungen einteiliger Anschlussstifte 3.

Weiterhin können gemäss Fig. 3d jeweils zwei Anschlussstifte 3, 3′ vorgesehen sein, deren Gesamtquerschnitt einem einteiligen Anschlussstift entspricht. Die Wicklungsenden 4 werden in diesem Falle wiederum lagenweise um beide Anschlussstifte 3, 3′ gelegt, wobei der Zwischenraum 7 zwischen den beiden Stiften 3, 3′ die Funktion der Einbuchtungen 5 bei der einteiligen Ausführung der Anschlussstifte 3 übernimmt.

Ferner ist es möglich, die Anschlussstifte so auszubilden, dass eine Vielzahl dünnerer Anschlussstifte mit einem in etwa gleichem Querschnitt eines einteiligen Anschlussstiftes 3 dessen Funktion übernimmt. Wie in der Fig. 3e dargestellt, können beispielsweise drei Anschlussstifte 3, 3′, 3″ in Form eines gleichseitigen Dreiecks angeordnet und von den Wicklungsenden 4 umwickelt werden. Diese Ausbildung wird sich überall dort empfehlen, wo unterschiedlich starke Drähte für die Wicklungen 2 verwendet werden, da dabei eine stärkere Entgasung der Isolationsschichten auftritt.

Die in den Zeichnungen dargestellte und vorstehend zu den Fig. 3a bis 3e beschriebene Ausbildung der Anschlussstifte 3, 3′, 3″ ist auf die gezeigten Querschnittsformen nicht beschränkt. So könnte beispielsweise eine schraubenförmige Ausbildung oder jede andere mögliche Form, beispielsweise T-, I- oder Diabolo-Form als geeigneter Querschnitt infrage kommen, solange zwischen dem Anschlussstiftkörper und der aus den Wicklungsenden 4 gebildeten Lagenwicklung über den Umfang des Anschlussstiftes 3 zwischen den einzelnen Auflageflächen der Wicklungsenden 4 ein von diesen frei überdeckter Hohlraum bzw. Einbuchtungen 5 oder Spalte 6 gebildet werden, welche einmal zum Abzug der Verbrennungsgase der Lackisolation und zum anderen zum Umspülen der Drahtenden mit Lötzinn und damit in axialer Richtung zur festen Verbindung der lagenweisen Wicklungsenden 4 untereinander dienen.

Durch Aufrauhen der Anschlussstift-Oberfläche kann zusätzlich ein verbesserter Halt der Drahtenden an den Anschlussstiften 3, 3′, 3″ erzielt werden.

Beim Verzinnen der mit den Wicklungsenden 4 bewickelten Steckeranordnung werden die fertig bewickelten Anschlussstifte 3, 3′, 3″ in ein Zinnbad eingetaucht. Die Hohlräume, welche durch die Einbuchtungen 5 und die Spalte 6 bei den ein- bzw. mehrteiligen Ausbildungen zwischen den Anschlussstiften 3, 3′, 3″ und den Wicklungsenden 4 vorhanden sind, werden beim Eintauchen in das mit flüssigem Zinn gefüllte Zinnbad umspült, wobei gleichzeitig durch die darin herrschende Temperatur die Lackisolation abbrennt, dabei Gase bildet, die durch die Einbuchtungen 5 und die Spalte 6 entweichen können, so dass die Wicklungsenden 4 ohne Blasenbildung und ohne Absplitterungen des Lötzinns von diesem überzogen werden. Anschliessend ist eine sichere Montage durch Einstecken in die, bzw. Auflöten auf die Leiterplatte möglich.

**Patentansprüche**

1. Steckanordnung für Leiterplatten für elektrische Spulen mit einem mit profilierten Anschlussstiften versehenen Spulenkörper (1) aus einem nichtmetallischen Werkstoff und mit die Anschlussstifte (3, 3′, 3″) radial umschliessenden Wicklungsenden, dadurch gekennzeichnet, dass die Anschlussstifte (3, 3', 3'') aus Kunststoff einstückig mit dem Kunststoffspulenkörper (1) ausgebildet sind und dass die Anschlussstifte im Querschnitt derart profiliert sind, dass die Profileinbuchtungen (5) vom Lötzinn in Längsrichtung hinterflossen werden.

2. Steckanordnung nach Anspruch 1, dadurch gekennzeichnet, dass die Anschlussstifte (3) einteilig ausgebildet sind.

3. Steckanordnung nach Anspruch 1, dadurch gekennzeichnet, dass die Anschlussstifte (3) einen runden Querschnitt mit Einbuchtungen (5) aufweisen.

4. Steckanordnung nach Anspruch 1, dadurch gekennzeichnet, dass die Anschlussstifte (3) einen quadratischen Querschnitt mit Einbuchtungen (5) aufweisen.

5. Steckanordnung nach Anspruch 1, dadurch gekennzeichnet, dass die Anschlussstifte (3) einen sternförmigen Querschnitt mit Einbuchtungen (5) aufweisen.

6. Steckanordnung nach Anspruch 1, dadurch gekennzeichnet, dass die Anschlussstifte (3, 3', 3'') mehrteilig ausgebildet sind.

7. Steckanordnung nach den Ansprüchen 1 bis 6, dadurch gekennzeichnet, dass die Profilierung der Anschlussstifte (3, 3', 3'') in axialer Richtung verläuft.

8. Steckanordnung nach den Ansprüchen 1 bis 6, dadurch gekennzeichnet, dass die Profilierung schraubenförmig ausgebildet ist.

9. Steckanordnung nach den Ansprüchen 1 bis 6, dadurch gekennzeichnet, dass die Oberfläche der Anschlussstifte (3, 3', 3'') rauh ausgebildet ist.

## Revendications

1. Dispositif d'enfichage pour des plaquettes de circuits imprimés pour des bobines électriques, comportant un corps de bobine (1) en matériau non métallique, muni de broches de raccordement profilées, les extrémités de l'enroulement entourant radialement les broches de raccordement (3, 3', 3''), caractérisé en ce que les broches de raccordement (3, 3', 3'') sont réalisées en matière plastique d'une seule pièce avec le corps de bobine en matière plastique (1) et en ce qu'elles ont en section transversale un profil tel que l'étain de soudure coule dans les encoches du profilé dans le sens longitudinal.

2. Dispositif d'enfichage selon la revendication 1, caractérisé en ce que les broches de raccordement (3) sont réalisées d'une seule pièce.

3. Dispositif d'enfichage selon la revendication 1, caractérisé en ce que les broches de raccordement (3) ont une section transversale ronde avec des encoches (5).

4. Dispositif d'enfichage selon la revendication 1, caractérisé en ce que les broches de reccordement (3) ont une section transversale carrée avec des encoches (5).

5. Dispositif d'enfichage selon la revendication 1, caractérisé en ce que les broches de raccordement (3) ont une section transversale en forme d'étoile avec des encoches (5).

6. Dispositif d'enfichage selon la revendication 1, caractérisé en ce que les broches de raccordement (3, 3', 3'') sont réalisées en plusieurs parties.

7. Dispositif d'enfichage selon les revendications 1 à 6, caractérisé en ce que le profilage des broches de raccordement (3, 3', 3'') s'étend dans le sens axial.

8. Dispositif d'enfichage selon les revendications 1 à 6, caractérisé en ce que le profilage est réalisé sous forme d'hélice.

9. Dispositif d'enfichage selon les revendications 1 à 6, caractérisé en ce que la surface des broches de raccordement (3, 3', 3'') est rugueuse.

## Claims

1. Plugging arrangement for printed circuit boards for electrical coils having a coil body (1) of a nonmetallic material provided with profiled connector pins and having coil ends radially surrounding the connector pins (3, 3', 3''), characterised in that the connector pins (3, 3', 3'') are constructed of plastics material in one piece with the plastics coil body (1) and that the connector pins are so profiled in cross-section that the profile recesses (5) are filled with solder in the longitudinal direction.

2. Plugging arrangement as claimed in claim 1, characterised in that the connector pins (3) are of one-piece construction.

3. Plugging arrangement as claimed in claim 1, characterised in that the connector pins (3) have a round cross-section with recesses (5).

4. Plugging arrangement as claimed in claim 1, characterised in that the connector pins (3) have a rectangular cross-section with recesses (5).

5. Plugging arrangement as claimed in claim 1, characterised in that the connector pins (3) have a star-shaped cross-section with recesses (5).

6. Plugging arrangement as claimed in claim 1, characterised in that the connector pins (3, 3', 3'') are of multi-piece construction.

7. Plugging arrangement as claimed in claims 1 to 6, characterised in that the profiling of the connector pins (3, 3', 3'') extends in the axial direction.

8. Plugging arrangement as claimed in claims 1 to 6, characterised in that the profiling is of spiral shape.

9. Plugging arrangement as claimed in claims 1 to 6, characterised in that the surface of the connector pins (3, 3', 3'') is rough.

FIG.1

FIG.2

FIG.3a

FIG.3b

FIG.3c

FIG.3d

FIG.3e